# EUROPÄISCHE PATENTSCHRIFT

(11) **EP 3 695 691 B1**
(45) Veröffentlichungstag und Bekanntmachung des Hinweises auf die Patenterteilung: **20.03.2024**
(21) Anmeldenummer: 18786659.5
(22) Anmeldetag: 08.10.2018
(51) Int. Cl.: H05K 1/02, H05K 3/34, H05K 1/11, H05K 3/42

(54) **VERFAHREN ZUM ERZEUGEN EINER LEITERPLATTE MIT THERMISCHEN DURCHKONTAKTIERUNGEN, SOWIE LEITERPLATTE**
METHOD FOR PRODUCING A PRINTED CIRCUIT BOARD HAVING THERMAL THROUGH-CONTACTS, AND PRINTED CIRCUIT BOARD
PROCÉDÉ DE GÉNÉRATION D'UNE CARTE DE CIRCUIT IMPRIMÉ AVEC DES TROUS D'INTERCONNEXION THERMIQUE, AINSI QUE CARTE DE CIRCUIT IMPRIMÉ

(30) Priorität: 12.10.2017 AT 508712017
(43) Veröffentlichungstag der Anmeldung: 19.08.2020
(73) Patentinhaber: ZKW Group GmbH, 3250 Wieselburg (AT)
(72) Erfinder: EDLINGER, Erik, 1090 Wien (AT)
(74) Vertreter: Patentanwaltskanzlei Matschnig & Forsthuber OG
(86) Internationale Anmeldenummer: PCT/AT2018/060235
(87) Internationale Veröffentlichungsnummer: WO 2019/071283

(56) Entgegenhaltungen:
- JP-A- H01 211 992
- US-A1- 2005 158 668
- US-A1- 2012 181 067

## Beschreibung

Die Erfindung betrifft ein Verfahren zum Erzeugen thermischer Durchkontaktierungen in einer Leiterplatte, ausgehend von einer Trägerplatte mit einer Vielzahl von darin vorgeformten Bohrungen, welche zwischen der Unterseite und der Oberseite der Trägerplatte gebildet sind und sich an Positionen befinden, wo jeweils thermische Durchkontaktierungen zu erzeugen sind.

Leiterplatten der hier betrachteten Art werden in der Elektronikindustrie weithin verwendet. Sie beinhalten eine Trägerplatte, die eine Anzahl von elektronischen Komponenten - im Folgenden meist "elektronische Bauteile" oder kurz "Bauteile" genannt - trägt, in der Regel auf einer Seite der Trägerplatte. Der Begriff "elektronischer Bauteil" ist dahingehend zu verstehen, dass er jegliche elektrischen Komponenten umfassen soll, die mit Leiterbahnen in elektrischer Verbindung stehen können, wie Chips, die integrierte Schaltungen beinhalten, digitale oder analoge Prozessoren aber auch einfachere Bauelemente, wie LEDs, Widerstände und dgl. mehr.

Die die Bauteile tragende Seite der Leiterplatte bzw. Trägerplatte wird im Rahmen dieser Offenbarung als "Oberseite" bezeichnet; die dieser gegenüber liegende Seite wird als "Unterseite" bezeichnet. Elektrische Verbindungsleitungen für die Bauteile und gegebenenfalls andere elektrische Installationen können sich auf beiden Seiten der Leiterplatte befinden, typischer Weise überwiegend auf der Unterseite. Bei einer Leiterplatte, die eine beidseitige Bestückung mit Bauteilen aufweist, wird in dieser Offenbarung diejenige Seite, die zuerst mit Bauteilen bestückt wird, als "Unterseite" bezeichnet. In besonderen Fällen kann auch vorgesehen sein, dass für verschiedene Bereiche der Trägerplatte die Rollen der Unter- und Oberseite vertauscht sind, beispielsweise wenn Bauteile in gewissen Bereichen bevorzugt auf der gegenüberliegenden Seite (die in diesen Bereichen dann als Oberseite betrachtet wird, sonst als Unterseite) zu montieren sind.

Der Körper der Trägerplatte besteht herkömmlicher Weise aus einem Kunststoff- oder Verbundmaterial, wie z.B. FR4, einem Epoxidharz-Glasfaser-Material; geeignete Leiterplattenmaterialien sind an sich bekannt.

Begriffe hinsichtlich des Ortes oder einer Orientierung, wie beispielsweise "oben", "unten", "vorne", "darunter", "darüber" etc. werden in der Beschreibung lediglich zur Vereinfachung gewählt und beziehen sich in erster Linie auf die Darstellung in der Zeichnung, nicht jedoch notwendigerweise auf eine Gebrauchs- oder Einbaulage. Insbesondere dienen die Begriffe Oberseite und Unterseite in dieser Beschreibung und den Ansprüchen lediglich der Identifizierung der Seiten einer Trägerplatte und sind nicht als einschränkend zu verstehen. Selbstverständlich kann der Schaltungsträger auch in allen anderen möglichen Orientierungen, wie umgekehrt, stehend oder schräg verwendet bzw. in Geräte eingebaut werden.

Da die Bauteile aufgrund unvermeidlicher Verlustleistungen während des Betriebs Wärme erzeugen, ist in der Regel auch für eine ausreichende Ableitung der Wärme zu sorgen, um Beeinträchtigungen der Bauteile bis hin zu deren Zerstörung zu vermeiden. Nur in sehr einfachen Fällen ist eine Kühlung durch umgebende Luft und Wärmeleitung in der Leiterplatte ausreichend; zumeist müssen zusätzliche Maßnahmen zur passiven oder aktiven Kühlung getroffen werden. Ein bekannter Ansatz der Wärmeableitung von thermisch beanspruchten Bauteilen sind thermische Durchkontaktierungen; diese werden oft "Thermo-Vias" oder (englisch) "thermal vias" genannt, häufig auch kurz nur "Vias". Ein Via stellt eine thermisch (sowie in der Regel auch elektrisch) leitfähige Verbindung von der Leiterplatten-Oberseite auf die -Unterseite dar, um einen Wärmetransport quer durch die Leiterplatte zu erleichtern und den thermischen Widerstand des Leiterplattenmaterials zu überbrücken.

Die industriellen Anwendungen sehen häufig beidseitig eine sehr dichte Bestückung der Leiterplatte vor. Möchte man nun eine solche Leiterplatte thermisch optimieren und hierfür Durchkontaktierungen durch Vias einsetzen, ist es häufig erforderlich, dass sich diese Durchkontaktierungen direkt unter einem Bauteil befinden müssen, etwa weil die Vias das Bauteil direkt kühlen sollen oder anderweitig kein Platz für Vias zur Verfügung steht. Hierbei tritt zumeist das Problem auf, dass während eines Lötdurchlaufs, bei dem für die zweite Seite ein Bauteil auf die Rückseite einer bereits (von der Vorderseite her) gelöteten bzw. mit Lot gefüllten Durchkontaktierung bestückt werden soll, aufgrund der Unebenheit, die die Durchkontaktierung verursacht, ein Auftragen des Lots für den Lötvorgang, beispielsweise mittels Pastendrucks, nicht oder nur schwer möglich ist und/oder die zu bestückenden Bauteile nicht mehr in gut definierte Weise aufgesetzt werden können. Bekannte Lösungen zur Erzeugung von Vias sehen die Füllung mit Kupfer- oder Epoxid-Pasten vor. Diese gefüllten Vias sind jedoch mit einem beträchtlichen Mehraufwand und damit einhergehend gesteigerten Kosten verbunden. Als Alternative ist bekannt, die Vias ohne Füllung zu belassen; jedoch sind ungefüllte Vias wegen der geringeren Wärmeleitung unbefriedigend.

JP H01 211992 A offenbart ein Verfahren zum Erzeugen thermischer Durchkontaktierungen in einer Leiterplatte mit einer Vielzahl von darin vorgeformten Bohrungen, welche zwischen einer Unterseite und einer Oberseite der Trägerplatte gebildet sind und sich an Positionen befinden, wo jeweils thermische Durchkontaktierungen zu erzeugen sind, das die folgenden Schritte aufweist:- Aufbringen einer ersten und einer zweiten Lötstoppmaske auf die Unterseite bzw. die Oberseite, wobei die erste Lötstoppmaske bei den vorgeformten Bohrungen jeweils um den Rand jeder Bohrung auf der Unterseite einen von Lötstopplack freien Bereich aufweist, wobei die zweite Lötstoppmaske bei zumindest einem Großteil der vorgeformten Bohrungen jeweils mindestens bis zu dem Rand der Bohrung auf der Oberseite heranreicht;- Aufbringen von Lot auf die Unterseite und Aufschmelzlöten des Lots, wobei das Lot in die Bohrungen eindringt und auf der Unterseite konvexe, den Rand der jeweiligen Bohrungen überragende Menisken ausbildet.

US 2012/181067 A1 offenbart ein Verfahren zum Erzeugen thermischer Durchkontaktierungen in einer Leiterplatte mit einer Vielzahl von darin vorgeformten Bohrungen.

Es ist daher Aufgabe der vorliegenden Erfindung, ein Verfahren zur Herstellung von Leiterplatten mit Vias zu schaffen, das prozessstabil, zuverlässig und dennoch kostenschonend ist, selbst wenn die Vias eng gesetzt werden und auf Positionen, an denen ebenfalls elektronische Bauteile angebracht (bestückt) werden.

Diese Aufgabe wird durch ein Verfahren der eingangs genannten Art gelöst, das folgende Schritte umfasst:
- Aufbringen einer ersten und einer zweiten Lötstoppmaske auf die Unterseite bzw. die Oberseite, wobei die erste Lötstoppmaske bei den vorgeformten Bohrungen jeweils um den Rand jeder Bohrung auf der Unterseite einen von Lötstopplack freien Bereich aufweist, wobei die zweite Lötstoppmaske bei zumindest einem Großteil, vorzugsweise bei jeder, der vorgeformten Bohrungen jeweils mindestens bis zu dem Rand der Bohrung auf der Oberseite heranreicht, was nicht ausschließt, dass die zweite Lötstoppmaske über den Rand hinaus in den Bereich der Öffnung ragt;
- Aufbringen von Lot auf die Unterseite und Aufschmelzlöten des Lots, wobei das Lot in die Bohrungen eindringt und auf der Unterseite konvexe, den Rand der jeweiligen Bohrungen überragende Menisken ausbildet; und
- Freistellen von Bereichen auf der Oberseite, welche Bereiche zum Kontaktieren zumindest eines elektronischen Bauteils auf der Oberseite vorbestimmt sind und jeweils zumindest eine der thermischen Durchkontaktierungen umfassen, durch Entfernen der zweiten Lötstoppmaske zumindest in besagten Bereichen.

Diese technische Lösung ergibt einen Herstellungsprozess, der es ermöglicht, Vias im Lötprozess prozessstabil - d.h. unter Vermeidung von Lotperlen, die zu Kriechströmen oder Kurzschlüssen führen können, und anderen Formabweichungen des Lotmaterials - mit Lot zu füllen und die Bestückung mit Bauteilen auf bereits gefüllte Vias durchzuführen. Die Verwendung von Lot als Füllmaterial der Vias erbringt eine hohe Wärmeleitung durch die Vias, die deutlich über der von Kupfer- oder andern Pasten liegt. Die Erfindung sieht auch eine nachträgliche Lötstoppfreistellung nach einem ersten Aufschmelzlötvorgang vor, wodurch die Definition von Lötfeldern ("Pads") zum Bestücken der Bauteile ermöglicht wird. Durch diese technische Lösung ergibt sich auch eine bessere Qualität der Bestückung auf die gefüllten Vias, wobei ein Verkippen der Bauteile oder ein unzureichender Pastendruck vermieden werden kann.

Gemäß einer bevorzugten Ausgestaltung des erfindungsgemäßen Verfahren ist es vorteilhaft, wenn in der ersten Lötstoppmaske die von Lötstopplack freien Bereiche kreisringartig gestaltet sind. Hierbei ist es in vielen Fällen zudem günstig, wenn die von Lötstopplack freien Bereiche unmittelbar benachbarter Bohrungen einander berühren, wodurch zwischen den freien Bereichen Gebiete mit Lötstopplack gebildet sind, die vorzugsweise die Form von durch konkave Kurvensegmenten begrenzte Vierecken oder Dreiecken aufweisen.

Um die Durchführung der Freistellung auf der Oberseite zu erleichtern und die Toleranz gegenüber Ungenauigkeiten der Positionierung der Maske auf der Oberseite zu erhöhen, kann es zweckmäßig sein, wenn die zweite Lötstoppmaske bei zumindest einem Teil besagter Bohrungen über den Rand reicht und dort jeweils einen freistehenden einwärts ragenden Ring bildet. Dies ergibt zudem eine bessere Definition des Lotrandes an der jeweiligen Öffnung zur Oberseite und verhindert insbesondere ein unerwünschtes Abfließen des Lots.

Alternativ kann vorgesehen sein, dass die zweite Lötstoppmaske bei zumindest einem Teil besagter Bohrungen bis knapp an den Rand heranreicht oder, bevorzugt, mit dem Rand der Bohrung fluchtet. Dies ergibt einen sparsameren Einsatz des Lötstoppmaterials und erleichtert die nachträgliche Bearbeitung der Lötstoppmaske zum Erzeugen der Freistellungsbereiche.

Für eine leichtere Handhabung des Lötvorgangs kann es zweckmäßig sein, wenn die Trägerplatte während des Schrittes des Aufbringens von Lot mit der Unterseite nach oben orientiert gehalten wird.

Das erfindungsgemäße Verfahren kann durch den anschließenden zusätzlichen Schritt ergänzt werden, bei dem die Oberseite bestückt wird, nämlich mit zumindest einem Bauteil auf den freigestellten Bereichen zum Kontaktieren.

Des Weiteren ist es günstig, wenn die beim Aufschmelzlöten des Lots auf der Unterseite entstehenden Menisken konvexe Kalotten jeweils über den Bohrungen ausbilden. Unter dem Begriff Meniskus wird hier eine gekrümmte Oberfläche des (flüssigen oder wieder verfestigten) Lots verstanden, wobei die Form des Meniskus bevorzugt, aber nicht notwendigerweise, die einer Kalotte - d.h. Kugelkalotte oder Ellipsoidkalotte - aufweist, sondern im Allgemeinen auch abgeflacht, gegebenenfalls auch etwas eingedellt, sein kann, sofern dies für die jeweilige Anwendung zweckmäßig ist. Die Ausformung der Menisken als Kalotten ergibt zugleich eine große Oberfläche der Menisken und eine gut definierte Gestalt der Oberfläche der Menisken, was die gezielte Auslegung für die Wärmeableitung erleichtert. Zudem trägt eine große Oberfläche zu einer besseren Leistung der Wärmeabstrahlung bei, bzw. der Wärmeableitung, wenn z.B. später auf die Menisken wärmeabführende Elemente über eine Wärmeleitpaste aufgebracht werden.

Zusätzlich kann vorab der zusätzlichen Schritt des Auskleidens der vorgeformten Bohrungen mit einem Metall durchgeführt werden, vorzugsweise mit einem Metall hoher elektrischer Leitfähigkeit wie z.B. Kupfer; und vorzugsweise kann dieser Auskleidungsschritt durch ein galvanisches Verfahren erfolgen.

Um eine zuverlässige Verfüllung der Vias frühzeitig zu erreichen, ist es günstig, wenn während des Aufschmelzlötens des Lots die Bohrungen, in welche das Lot eindringt, durch das Lot aufgefüllt werden. Gleichfalls ist es günstig, wenn die Menisken durch Lotmaterial gebildet sind, welches zugleich die Bohrungen ausfüllt. Diese Ausgestaltungen ergeben Vias mit einer besonders guten thermischen Performance.

Ebenso wird die der Erfindung zugrunde liegende Aufgabe mit der Verwendung einer Leiterplatte gelöst, bei welcher die thermischen Durchkontaktierungen auf der Unterseite konvexe, den Rand der jeweiligen Bohrungen überragende Menisken aufweisen, und auf der Oberseite von einer Lötstoppmaske freigestellte Bereiche vorgesehen sind, welchen Bereiche mit Lötmaterial zum Kontaktieren zumindest eines elektronischen Bauteils auf der Oberseite ausgestattet sind und mit zumindest einer der thermischen Durchkontaktierungen in Lötverbindung stehen.

Weitere vorteilhafte Ausbildungen der Leiterplatte entsprechen jenen, die sich aus den Weiterbildungen des erfindungsgemäßen Verfahrens ergeben. Insbesondere können bei der Leiterplatte zudem die Menisken auf der Unterseite kreisförmig sein, wobei vorzugsweise die Menisken unmittelbar benachbarter Bohrungen einander berühren, wobei zwischen diesen Menisken jeweils Gebiete mit Lötstopplack liegen, die vorzugsweise die Form von durch konkave Kurvensegmenten begrenzte Vierecken oder Dreiecken aufweisen. Zusammenfassend erzielt die Erfindung die folgenden Vorteile:
- hohe thermische Performance,
- lediglich geringe Mehrkosten durch Füllen der Vias,
- Zuverlässigkeit der Füllung für Vias in Pads,
- Einsatzmöglichkeit der Freistellung auch für andere Anwendungen,
- eine nachträgliche Änderung der Lötstoppmaske ist bei Bedarf möglich, und
- die Vias können frühzeitig, bereits bei der Metallisierung (mittels HAL-Finish), mit Lot gefüllt werden.

Die Erfindung samt weiterer Vorzüge wird im Folgenden anhand beispielhafter Ausführungsformen erläutert, die in den Zeichnungen dargestellt sind. Die Zeichnungen zeigen in schematischer Form anhand einer Abfolge von Schnittansichten der jeweils gezeigten Trägerplatte:
- Fig. 1: eine Trägerplatte zeigt, die in einer ersten Ausführungsform der Erfindung verwendet wird, wobei die Trägerplatte vorläufig umgedreht ist, sodass ihre Unterseite nach oben gewandt ist;
- Fig. 2: die Trägerplatte mit aufgebrachten Lötstoppmasken, und zwar in einer Schnittansicht in Teilbild (a) sowie in einer Aufsicht auf die Unterseite der Trägerplatte in Teilbild (b);
- Fig. 3: illustriert das Aufbringen und Aufschmelzlöten von Lot;
- Fig. 4: zeigt den durch das Aufschmelzlöten erreichen Zustand mit gefüllten Bohrungen in der Trägerplatte;
- Fig. 5: illustriert den folgenden Schritt des Freistellens von Bereichen auf der Oberseite, wobei zuvor die Trägerplatte umgedreht wird;
- Fig. 6: illustriert den zusätzlichen Schritt des Bestückens der Trägerplatte mit elektronischen Bauteilen;
- Fig. 7: zeigt die so erhaltene Leiterplatte; und
- Fig. 8: zeigt eine Trägerplatte mit Lötstoppmasken, die in einer zweiten Ausführungsform der Erfindung verwendet wird.

Es versteht sich, dass die hier beschriebenen Ausführungsformen lediglich der Illustration dienen und nicht als für die Erfindung einschränkend aufzufassen sind; vielmehr fallen unter den Schutzbereich der Erfindung sämtliche Ausgestaltungen, die der Fachmann anhand der Beschreibung finden kann, wobei der Schutzbereich durch die Ansprüche festgelegt ist.

In den folgenden Figuren werden für gleiche oder vergleichbare Elemente zum Zwecke der einfacheren Erläuterung und Darstellung gleiche Bezugszeichen verwendet. Die in den Ansprüchen verwendeten Bezugszeichen sollen weiters lediglich die Lesbarkeit der Ansprüche und das Verständnis der Erfindung erleichtern und haben keinesfalls einen den Schutzumfang der Erfindung beeinträchtigenden Charakter.

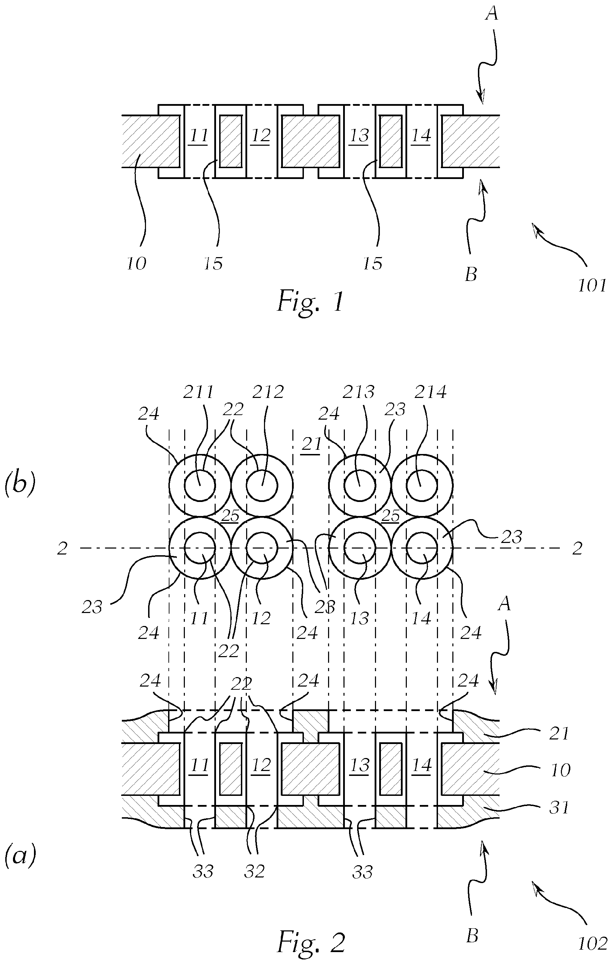

In Fig. 1 ist eine Trägerplatte 101 gezeigt, die in dem ersten Ausführungsbeispiel als Ausgangspunkt für das Herstellungsverfahren dient. Die in Fig. 1 und den darauffolgenden Figuren gezeigten Schnittansichten entsprechen einem Schnitt durch eine Reihe von Bohrungen, jeweils entlang einer Schnittebene, die der Schnittebene 2-2 in Fig. 2(a) entspricht, wobei jeweils das gleiche Teilstück der Trägerplatte in den aufeinanderfolgenden Stadien des Herstellungsverfahrens gezeigt ist.

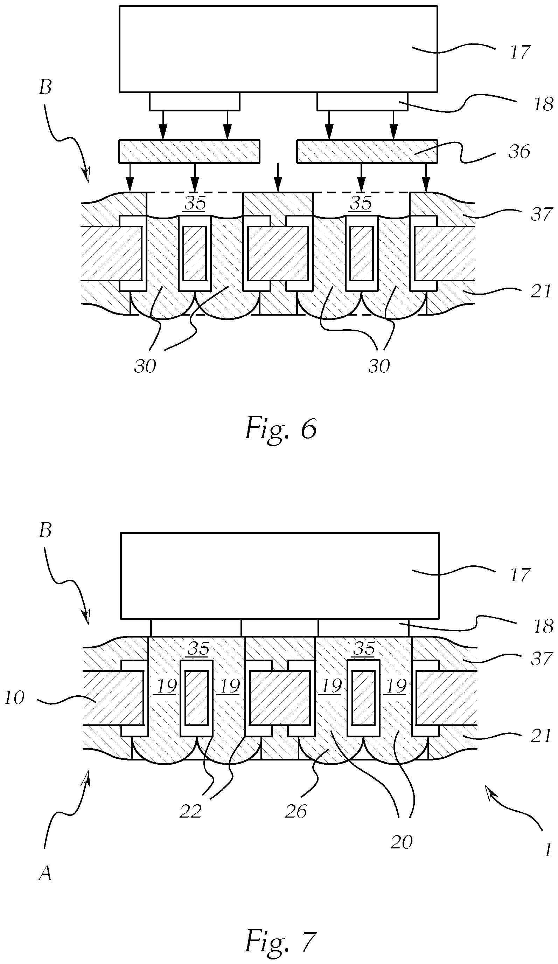

Die Trägerplatte 101 beinhaltet eine Grundplatte 10, beispielsweise eine ein-oder mehrlagige FR4-Platte; FR4-Platten als Grundplatten für Leiterplatten sind wohlbekannt. Die beiden Oberflächen der Trägerplatte entsprechen einer Unterseite A und einer Oberseite B. Es sei darauf hingewiesen, dass in den Darstellungen der Fig. 1 bis 4 die Trägerplatte "umgedreht" orientiert ist, d.h. die Unterseite A ist nach oben und die Oberseite B nach unten gewandt. Die Oberseite B ist wie eingangs erläutert jene Seite, auf der bei einseitiger Bestückung der Trägerplatte die elektronischen Bauteile aufgebracht werden (vgl. Fig. 6). Abhängig von dem Anwendungslayout der zu erzeugenden Leiterplatte kann auch vorgesehen sein, dass für verschiedene Bereiche der Trägerplatte die Rollen der Unter- und Oberseite vertauscht sind, beispielsweise wenn Bauteile in gewissen Bereichen auch auf der gegenüberliegenden Seite montiert werden.

In der Grundplatte 10 der Trägerplatte 101 ist eine Vielzahl von Bohrungen ausgebildet, von denen in Fig. 1 vier Bohrungen 11, 12, 13, 14 repräsentativ gezeigt sind und die mittels eines geeigneten bekannten Verfahrens erzeugt worden sind. Im Allgemeinen befinden sich die Bohrungen auf der Trägerplatte in einer im Vorhinein festgelegten, zweidimensionalen Anordnung. Die Positionen in der zweidimensionalen Anordnung werden je nach Anwendung und Anforderungen an den Stellen gewählt, wo jeweils Vias (thermische Durchkontaktierungen) erzeugt werden sollen; die tatsächlichen Positionen der Vias bzw. Bohrungen sind jedoch für die Erfindung nicht weiter von Belang. Die Bohrungen 11-14 (und ebenso die Bohrungen 211-214 der Fig. 2(b)) sind mit jeweils eigenen Bezugszeichen versehen, sind jedoch für die Zwecke der vorliegenden Offenbarung gleichartig ausgeführt.

Die Bohrungen 11-14 sind vorzugsweise, jedoch nicht notwendiger Weise, mit einer metallischen Auskleidung (Überzug) 15 versehen. Das metallische Material des Überzugs 15 weist vorzugsweise eine hohe elektrische Leitfähigkeit auf. Bevorzugte Materialien sind z.B. Kupfer, Aluminium oder Kohlenstoffbeschichtung. Diese Auskleidung wird beispielsweise unmittelbar nach dem Einbringen der Bohrungen in die Grundplatte 10 durch ein geeignetes, an sich bekanntes Verfahren erzeugt, z.B. ein galvanisches Verfahren. Die Auskleidung 15 ist in den Zeichnungen der Deutlichkeit halber mit übertriebener Dicke dargestellt.

Auf die Trägerplatte 101 werden nun beiderseits Lötstoppmasken 21, 31 aufgebracht. Dies ergibt die in Fig. 2 gezeigte Trägerplatte 102 mit einer ersten Lötstoppmaske 21 auf der Unterseite Ader Trägerplatte 102 und einer zweiten Lötstoppmaske 31 auf der Oberseite B der Trägerplatte 102, wie in der Schnittansicht der Fig. 2(a) ersichtlich. Die Höhe der Lötstoppmasken 21, 31 ist in den Figuren zum Zwecke der Deutlichkeit übertrieben dargestellt und ist in vielen Ausführungsformen deutlich geringer als gezeigt. Um im späteren Stadium des Verfahrens eine flächige Füllung der Vias zu ermöglichen, sind in den Lötstoppmasken 21, 31 freigestellte Bereiche vorgesehen, sodass die Lötstoppmasken jeweils zumindest Gebiete ausnehmen, die den Öffnungen der Bohrungen 11-14 auf der Ober- bzw. Unterseite entsprechen.

In Fig. 2(b) ist in einer Aufsicht der Trägerplatte 102 ein Ausschnitt der ersten Lötstoppmaske 21 gezeigt. Jede Bohrung - in Fig. 2(b) sind über die Bohrungen 11-14 hinaus auch Bohrungen 211, 212, 213, 214 einer parallel angeordneten, zweiten Reihe dargestellt - mündet auf der Unterseite in eine Öffnung, deren Rand in Fig. 2(b) als je ein Kreis ersichtlich ist: kleinere Kreise 22. Um jeden der Ränder 22 ist eine Lötstopplack-Freistellung 23 vorgesehen, sodass ein freier Bereich bis zu einem Außenrand, gezeigt als je ein größerer Kreis 24, verbleibt. Vorzugsweise werden die Freistellungsbereiche 23 werden, soweit möglich und mit der vorgesehenen elektronischen Struktur verträglich, so dicht aneinander gesetzt, dass die Außenränder 24 unmittelbar benachbarter Bohrungen 11, 12, 212, 211 bzw. 13, 14, 214, 211 einander berühren. Zwischen derart unmittelbar benachbarten Bohrungen verbleibt jeweils ein nicht benetzbares Gebiet 25 der Lötstoppmaske; dieses Gebiet 25 hat im gezeigten Beispiel die Form einer Raute oder "Karo"-Form. Diese Gebiete 25 sind vorgesehen, um im späteren Schritt die Menge des in den freigestellten Bereichen aufgenommen Lots zu begrenzen und um die Oberfläche des Lots besser zu definieren. Im Allgemeinen entspricht die Form eines solchen Gebiets, das von mehreren Freistellungsbereichen umgrenzt ist, einem "konkaven Polygon", d.h. einer polygonartigen Figur, die aus konkaven Kurvensegmenten, insbesondere Kreissegmenten, gebildet ist, zumeist einem konkaven Viereck oder konkaven Dreieck. Bei einem solchen "konkaven Polygon" treten somit anstelle geradliniger Kanten die erwähnten konkaven Kurven bzw. Kreissegmente. Zwischen Freistellungsbereichen, die für Vias, zwischen denen im elektronischen Layout kein elektrischer Kontakt zustande kommen darf, vorgesehen sind, verbleibt jedoch ein Steg mit einer im Vorhinein bestimmten Mindestbreite. Der Wert der Mindestbreite hängt jeweils von Layout-Vorgaben ab; ein typischer Wert ist z.B. 100 µm, kann jedoch auch 50 µm oder weniger betragen. Im Allgemeinen wird ein Wert gewählt, der eine elektrische Trennung zwischen den erzeugten Vias sicherstellt. In diesen Fällen laufen die "konkaven Polygone" an den Spitzen, die zwischen derartigen elektrische getrennten Vias liegen, in die erwähnten Stege aus und sind somit durch diese Stege gegebenenfalls miteinander verbunden.

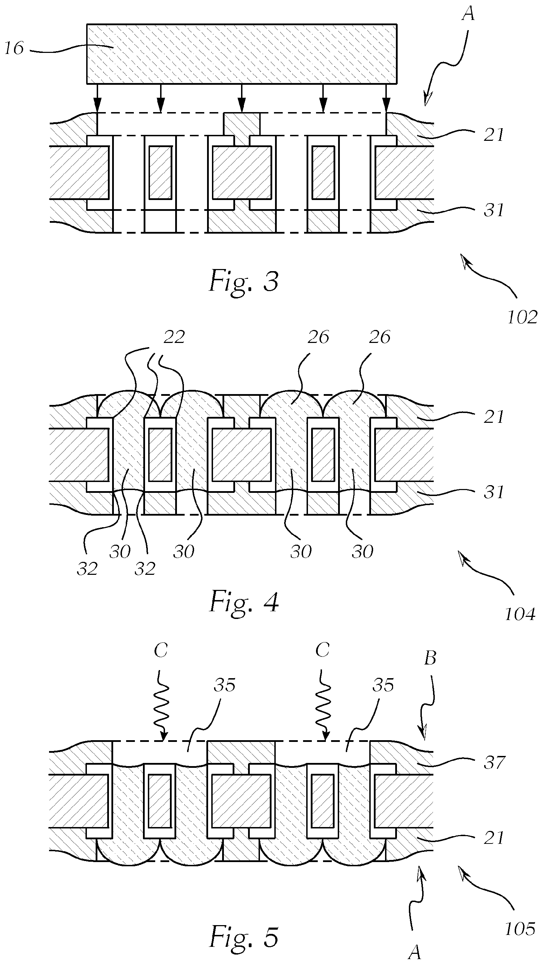

Auch auf der Oberseite - Lötstoppmaske 31 - sind an den Orten der Öffnungen der Bohrungen, entsprechend den Rändern 32, Freistellungen vorgesehen. Hier wird jedoch die Freistellung in der Lötstoppmaske 31 auf der Oberseite B bevorzugt möglichst klein ausgeführt; dies soll vermeiden, dass nach dem ersten Aufschmelzlöten des Lots in den Bohrungen befindliches Lotmaterial über die Oberfläche der Oberseite vorsteht (vgl. Fig. 4). Die Lötstoppmaske 31 reicht somit bevorzugt zumindest bis an die Ränder 32 der Bohrungen auf der Oberseite B. In der gezeigten Ausführungsform ist die Freistellung derart, dass der Rand 33 der zweiten Lötstoppmaske 31 mit dem Rand 32 der Bohrung fluchtet. Hier entspricht somit bei jeder Bohrung der Rand 33 der Lötstoppmaske 31 dem Bohrungsrand 32. Alternativ kann in einer nicht dargestellten Ausführungsvariante auch ein schmaler Freistellungsbereich um den Rand 32 ausgenommen sein, sodass der Rand der Lötstoppmaske knapp an den Rand 32 heranreicht; der verbleibende Abstand zum Rand 32 ist gering, damit der über der Öffnung der Bohrung entstehende Meniskus nicht über die Oberfläche der oberseitigen Lötstoppmaske 31 vorsteht.

Beispielhafte Abmessungen in der Lötstoppmaske 21 sind 0,7 mm Durchmesser der Freistellungsbereiche 23 bei einem Durchmesser der Öffnungen 22, 32 von 0,35 mm.

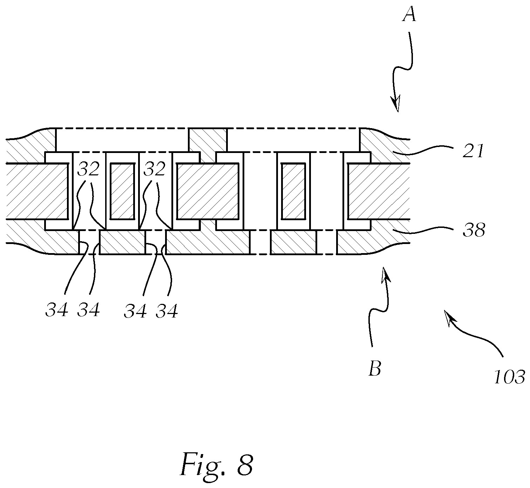

In einer vorteilhaften Ausführungsvariante, die in Fig. 8 in einer Schnittansicht einer Trägerplatte 103 gezeigt ist, kann die Lötstoppmaske auf der Oberseite B dahingehend abgewandelt sein, dass die Lötstoppmaske 38 über die Ränder 32 der Bohrungen in die jeweiligen Öffnungen hinein ragt. Die Lötstoppmaske 38 bildet somit bei diesen Bohrungen jeweils einen freistehenden einwärts ragenden Ring 34 aus. Dieser Ring 34 beugt einem unerwünschten Abfließen des Lots vor, was zu unerwünschten Voids im Via führen könnte. Derartige überstehende Ringe 34 können bei allen Bohrungen oder bei einem Teil der Bohrungen vorgesehen sein. Im Übrigen entspricht die Trägerplatte 103 der Fig. 8 der Trägerplatte 102 der Fig. 2.

Die Vias werden vorteilhafterweise nicht mit Lötstopplack verschlossen, weil dies vermeidet, dass es zu Lufteinschlüssen im Via kommt und eine effiziente Füllung beeinträchtigt. Die Lötstoppmaske 31, 38 verhindert somit, dass Lot über die Öffnungen hinaus austreten kann, und gleichzeitig wird durch die verbleibenden Öffnungen (gemäß den Rändern 33 bzw. 34) selbst ein Ausgasen des Flussmittels ermöglicht. Dies sorgt für ein Ausbilden der Vias ohne unerwünschte Voids (Hohlräume).

Bezugnehmend auf Fig. 3 wird sodann im nächsten Schritt, nämlich einem ersten Aufschmelzlöt-Durchlauf beispielsweise mittels des bekannten SMT-Verfahrens, auf die Unterseite A Lot 16 aufgebracht. In Fig. 3 ist das Lot 16 symbolisch durch ein Rechteck mit unterbrochener Schraffierung dargestellt. Vorzugsweise wird die Trägerplatte zumindest während dieses Schrittes mit der Unterseite A nach oben orientiert gehalten. Während des Aufschmelzlötens dringt das Lot 16 in die Bohrungen 11, 12, 13, 14 ein, wobei es bis an die Ränder der Lötstoppmasken 21, 31 vordringt.

Der so erhaltene Zustand der Trägerplatte 104 ist in Fig. 4 dargestellt. Das Lot dringt vorteilhafterweise auf der Unterseite A bis an die Ränder 24 der Freistellungsbereiche 23 der Lötstoppmaske 21 vor, sodass weitgehend verfüllte Bohrungen 30 erhalten werden. Das Lot 16 bildet hierbei Menisken 26 auf den Bereichen 23 aus, die über die unterseitigen Ränder 22 der Bohrungen 30 ragen. Diese Menisken 26 erhalten bevorzugt durch eine geeignete Wahl von Lotmaterial und -menge eine derartige Gestalt, dass sie viele kleine "Hügel" in Form konvexer Kalotten ausbilden. Dies ergibt eine vergrößerte Oberfläche der Menisken, was die Abstrahlung bzw. Ableitung von Wärme verbessert. Die Menisken 26 entsprechen in ihrer Anordnung naturgemäß der Anordnung der Freistellungsbereiche 23 (siehe Fig. 2(b)), sodass sie vorzugsweise einander berühren, wogegen zwischen den Menisken 26 die oben beschriebenen Gebiete 25 mit Lötstopplack verbleiben.

Gegebenenfalls können gemäß einer Variante des Verfahrens während des ersten Aufschmelzlöt-Durchlaufs der Fig. 3 und 4 zugleich (nicht gezeigte) Bauteile auf der Unterseite A bestückt werden.

Auf der Oberseite B dagegen sind derartige Menisken in diesem Stadium möglich, aber nicht erforderlich, im Hinblick auf den späteren Lötdurchlauf für die Oberseite, wie weiter unten beschrieben.

Bezugnehmend auf Fig. 5 erfolgt sodann ein Schritt des Freistellens von Bereichen 35 auf der Oberseite B. Hierfür ist es in der Regel zweckmäßig, dass die Trägerplatte vorher gewendet wird, sodass von nun an die Oberseite B nach oben gewandt ist. Die Bereiche 35 werden im Vorhinein festgelegt und entsprechen jenen Bereichen, auf denen im nachfolgenden Schritt elektronische Bauteile kontaktiert werden. Zumindest einige der Bereiche 35 umfassen hierbei auch die Stellen von einer oder mehreren der zuvor erzeugten verfüllten Bohrungen 30.

Dieser Schritt des Freistellens dient dazu, dass die Bereiche 35 frei von Lötstopplack gemacht werden . Hierzu werden jene Teile der Lötstoppmaske 31, welche sich in den Bereichen 35 befinden, mithilfe geeigneter bekannter Verfahren C entfernt, beispielsweise mit einem chemischen oder plasmachemischen Ätzverfahren bekannter Art, mithilfe lithographischer Verfahren, oder unter Verwendung eines Markierungslasers C. Außerhalb dieser Bereiche 35 verbleibt zweckmäßiger Weise der Lötstopplack der so bearbeiteten Lötstoppmaske 37.

Sodann erfolgt, wie in Fig. 6 dargestellt, im nächsten Schritt ein zweiter Aufschmelzlöt-Durchlauf auf der Oberseite B, beispielsweise mittels des bekannten SMT-Verfahrens. Hierbei wird die Oberseite wiederum nach an sich bekannter Art mit Lotmaterial 36 bedruckt und mit Bauteilen bestückt; in Fig. 6 ist repräsentativ ein Bauteil 17 für eine im Allgemeinen beliebige Anzahl von Bauteilen gezeigt. Das Lot 36 dringt somit während des Aufschmelzlötens in die freigestellten Bereiche 35 ein und verbindet sich andererseits mit den Kontaktflächen 18 der Bauteile 17. Hierdurch ergibt sich eine direkte Verbindung der Kontaktflächen 18 mit den verfüllten Bohrungen 20.

Fig. 7 zeigt die so erhaltene Leiterplatte 1. An den Stellen der Bohrungen 20 sind nunmehr eine Anzahl von Vias 19 ausgebildet, die mit Lotmaterial verfüllt sind, das unterbrechungsfrei bis an die Kontaktflächen 18 der Bauteile 17 auf der Oberseite B (sowie gegebenenfalls der Unterseite A; nicht gezeigt) reicht und so für eine gute thermische und gegebenenfalls elektrische Kontaktierung der Bauteile sorgt.

Das erfindungsgemäße Verfahren ermöglicht es somit, dass Vias 19 eine Position direkt unter Bauteilen 17 haben und dennoch gezielt gefüllt werden können, ohne dabei eine Beeinträchtigung des Pastendrucks im SMT-Vorgang oder ein Verkippen der Bauteile 17 in Kauf nehmen zu müssen.

## Patentansprüche

1. Verfahren zum Erzeugen thermischer Durchkontaktierungen (19) in einer Leiterplatte, ausgehend von einer Trägerplatte (101) mit einer Vielzahl von darin vorgeformten Bohrungen (11, 12, 13, 14), welche zwischen einer Unterseite (A) und einer Oberseite (B) der Trägerplatte (101) gebildet sind und sich an Positionen befinden, wo jeweils thermische Durchkontaktierungen zu erzeugen sind, die folgenden Schritte umfassend:
- Aufbringen einer ersten und einer zweiten Lötstoppmaske (21, 31) auf die Unterseite (A) bzw. die Oberseite (B), wobei die erste Lötstoppmaske (21) bei den vorgeformten Bohrungen (11-14) jeweils um den Rand (22) jeder Bohrung auf der Unterseite einen von Lötstopplack freien Bereich (23) aufweist, wobei die zweite Lötstoppmaske (31) bei zumindest einem Großteil, vorzugsweise bei jeder, der vorgeformten Bohrungen (11-14) jeweils mindestens bis zu dem Rand (32) der Bohrung auf der Oberseite heranreicht;
- Aufbringen von Lot (16) auf die Unterseite (A) und Aufschmelzlöten des Lots, wobei das Lot in die Bohrungen (11-14) eindringt und auf der Unterseite (A) konvexe, den Rand (22) der jeweiligen Bohrungen überragende Menisken (26) ausbildet; und sodann
- Freistellen von Bereichen (35) auf der Oberseite (B), welche Bereiche zum Kontaktieren zumindest eines elektronischen Bauteils (18) auf der Oberseite vorbestimmt sind und jeweils zumindest eine der thermischen Durchkontaktierungen umfassen, durch Entfernen der zweiten Lötstoppmaske (31) zumindest in besagten Bereichen.

2. Verfahren nach Anspruch 1, **dadurch gekennzeichnet, dass** die erste Lötstoppmaske (21) die von Lötstopplack freien Bereiche (23) kreisringartig gestaltet sind.

3. Verfahren nach Anspruch 2, **dadurch gekennzeichnet, dass** die von Lötstopplack freien Bereiche (23) unmittelbar benachbarter Bohrungen einander berühren, wodurch zwischen den freien Bereichen Gebiete (25) mit Lötstopplack gebildet sind, die vorzugsweise die Form von durch konkave Kurvensegmenten begrenzte Vierecken oder Dreiecken aufweisen.

4. Verfahren nach einem der vorhergehenden Ansprüche, **dadurch gekennzeichnet, dass** die zweite Lötstoppmaske (31) bei zumindest einem Teil besagter Bohrungen über den Rand (32) reicht und dort jeweils einen freistehenden einwärts ragenden Ring (34) bildet.

5. Verfahren nach einem der vorhergehenden Ansprüche, **dadurch gekennzeichnet, dass** die zweite Lötstoppmaske (31) bei zumindest einem Teil besagter Bohrungen an den Rand (32) heranreicht, wobei bei diesen Bohrungen der Rand (33) der zweiten Lötstoppmaske mit dem Rand (32) der Bohrung fluchtet.

6. Verfahren nach einem der vorhergehenden Ansprüche, **dadurch gekennzeichnet, dass** die Trägerplatte während des Schrittes des Aufbringens von Lot mit der Unterseite (A) nach oben orientiert gehalten wird.

7. Verfahren nach einem der vorhergehenden Ansprüche, **gekennzeichnet durch** den anschließenden zusätzlichen Schritt:
- Bestücken der Oberseite (B) mit zumindest einem elektronischen Bauteil (18) auf den freigestellten Bereichen (35) zum Kontaktieren.

8. Verfahren nach einem der vorhergehenden Ansprüche, **dadurch gekennzeichnet, dass** die beim Aufschmelzlöten des Lots auf der Unterseite (A) entstehenden Menisken (26) konvexe Kalotten jeweils über den Bohrungen ausbilden.

9. Verfahren nach einem der vorhergehenden Ansprüche, **gekennzeichnet durch** den vorab durchgeführten zusätzlichen Schritt:
- Auskleiden der vorgeformten Bohrungen (11-14) mit einem Metall, vorzugsweise einem Metall hoher elektrischer Leitfähigkeit wie z. B. Kupfer, und vorzugsweise durch ein galvanisches Verfahren.

10. Verfahren nach einem der vorhergehenden Ansprüche, **dadurch gekennzeichnet, dass** während des Aufschmelzlöten des Lots die Bohrungen (11-14), in welche das Lot (16) eindringt, durch das Lot (16) aufgefüllt werden.

## Claims

1. Method for producing thermal vias (19) in a printed circuit board, starting from a carrier plate (101) comprising, preformed therein, a plurality of bores (11, 12, 13, 14) being formed between an lower side (A) and an upper side (B) of the carrier plate (101) and located at positions where respective thermal vias are to be produced, comprising the following steps:
- applying a first solder resist mask and a second solder resist mask (21, 31) to the lower side (A) and the upper side (B), respectively, wherein the first solder resist mask (21) at the preformed bores (11-14) comprises, around the edge (22) of each bore on the lower side, a respective area (23) free of solder resist, wherein the second solder resist mask (31), with regard to at least a large part of, preferably each of, the preformed bores (11-14), extends to at least the edge (32) of the bore on the upper side;
- applying solder (16) to the lower side (A) and fusion soldering the solder, the solder entering into the bores (11-14) and forming, on the lower side (A), convex menisci (26) projecting beyond the edge (22) of the respective bores; and then
- uncovering areas (35) on the upper side (B), which areas are destined for contacting at least one electronic component (18) on the upper side and respectively include at least one of the thermal vias, by removing the second solder resist mask (31) at least in said areas.

2. Method according to claim 1, **characterized in that** at the first solder resist mask (21) the areas (23) free of solder resist are shaped as circular rings.

3. Method according to claim 2, **characterized in that** the areas (23) free of solder resist pertinent to immediately adjacent bores touch each other, thus forming areas (25) having solder resist between the free areas, which preferably have the shape of quadrilaterals or triangles bounded by concave curve segments.

4. Method according to any one of the preceding claims, **characterized in that** the second solder resist mask (31) extends over the edge (32) of at least part of said bores and at these positions forms respective self-supporting rings (34) projecting inwardly.

5. Method according to any one of the preceding claims, **characterized in that** the second solder resist mask (31) extends to the edge (32) of at least a part of said bores, wherein at these bores the edges (33) of the second solder resist mask are aligned with the edges (32) of the respective bores.

6. Method according to any one of the preceding claims, **characterized in that** during the step of applying solder the carrier plate is kept oriented with the lower side (A) facing upwards.

7. Method according to any one of the preceding claims, **characterized by** the subsequent additional step:
- equipping the upper side (B) with at least one electronic component (18) on the uncovered areas (35) for contacting.

8. Method according to any one of the preceding claims, **characterized in that** the menisci (26) generated on the lower side (A) during fusion soldering of the solder form convex domes over the respective bores.

9. Method according to any one of the preceding claims, **characterized by** the additional step carried out beforehand:
- lining the preformed bores (11-14) with a metal, preferably a metal of high electrical conductivity such as copper, and preferably by an electroplating process.

10. Method according to any one of the preceding claims, **characterized in that** during the fusion soldering of the solder, the bores (11-14) into which the solder (16) enters are filled by the solder (16).

## Revendications

1. Procédé de production d'alésages d'interconnexion thermiques (19) dans une carte de circuit imprimé, à partir d'une carte de support (101) comportant une pluralité d'alésages (11, 12, 13, 14) préformés dans celle-ci, qui sont formés entre une face inférieure (A) et une face supérieure (B) de la carte de support (101) et qui sont situés à des positions où des alésages d'interconnexion thermiques respectifs doivent être produits, comprenant les étapes suivantes :
- appliquer un premier et un deuxième masque d'arrêt de soudure (21, 31) sur la face inférieure (A) et la face supérieure (B) respectivement, le premier masque d'arrêt de soudure (21) présentant, pour les alésages préformés (11-14), autour des bords (22) des alésages respectives sur la face inférieure, une zone (23) exempte de vernis d'arrêt de soudure, le deuxième masque d'arrêt de soudure (31) s'étendant, pour au moins une grande partie des alésages préformés (11-14), de préférence pour chacun de ceux-ci, au moins jusqu'au bord (32) de l'alésage respectif sur la face supérieure ;
- appliquer de matériau à brasage (16) sur la face inférieure (A) et braser par fusion du matériau, le matériau à brasage entrant dans les alésages (11-14) et formant sur la face inférieure (A) des ménisques convexes (26) dépassant le bord (22) des alésages respectifs ; et ensuite
- dégager des zones (35) sur la face supérieure (B), lesquelles zones sont destinées à la mise en contact d'au moins un composant électronique (18) sur la face supérieure et comprennent chacune au moins l'un des alésages d'interconnexion thermiques, par enlèvement du deuxième masque de soudure (31) au moins dans lesdites zones.

2. Procédé selon la revendication 1, **caractérisé en ce que** le premier masque d'arrêt de soudure (21) présente les zones (23) exemptes de vernis d'arrêt de soudure sous forme d'anneau circulaire.

3. Procédé selon la revendication 2, **caractérisé en ce que** les zones exemptes de vernis (23) d'alésages immédiatement adjacents sont en contact les unes avec les autres, formant ainsi entre les zones exemptes des zones (25) de vernis d'arrêt de soudure, qui ont de préférence la forme de carrés ou de triangles délimités par des segments de courbe concaves.

4. Procédé selon l'une quelconque des revendications précédentes, **caractérisé en ce que** le deuxième masque d'arrêt de soudure (31) s'étend au-delà du bord (32) d'au moins une partie desdits alésages et y forme respectivement un anneau libre (34) faisant saillie vers l'intérieur.

5. Procédé selon l'une quelconque des revendications précédentes, **caractérisé en ce que** le deuxième masque d'arrêt de soudure (31) s'étend jusqu'au bord (32) d'au moins une partie desdits alésages, le bord (33) du deuxième masque d'arrêt de soudure étant aligné avec le bord (32) de l'alésage dans ces alésages.

6. Procédé selon l'une quelconque des revendications précédentes, **caractérisé en ce que** la carte de support est maintenue orientée avec la face inférieure (A) vers le haut pendant l'étape d'application de la soudure.

7. Procédé selon l'une quelconque des revendications précédentes, **caractérisé par** l'étape supplémentaire suivante :
- garnir la face supérieure (B) d'au moins un composant électronique (18) sur les zones exposées (35) pour établir le contact.

8. Procédé selon l'une quelconque des revendications précédentes, **caractérisé en ce que** les ménisques (26) formés sur la face inférieure (A) lors du brasage par fusion du matériau à brasage forment des calottes convexes respectivement au-dessus des alésages.

9. Procédé selon l'une quelconque des revendications précédentes, **caractérisé par** l'étape supplémentaire réalisée préalablement :
- revêtir les alésages préformés (11-14) avec un métal, de préférence un métal à haute conductivité électrique tel que le cuivre, et de préférence par un procédé de galvanisation.

10. Procédé selon l'une quelconque des revendications précédentes, **caractérisé en ce que**, pendant le brasage par fusion du matériau à brasage, les alésages (11-14) dans lesquels la soudure (16) entre sont remplis par le matériau à brasage (16).
